# EUROPEAN PATENT APPLICATION

(11) **EP 1 972 700 A1**
(43) Date of publication of application: **24.09.2008**
(21) Application number: 06833564.5
(22) Date of filing: 29.11.2006
(51) Int. Cl.: C23C 14/34, H01L 21/285, H05H 1/48

(54) **SHEET PLASMA FILM-FORMING APPARATUS**

(30) Priority: 06.12.2005 JP 2005351576
(71) Applicant: Shinmaywa Industries, Ltd., Takarazuka-shi, Hyogo 665-8550 (JP)
(72) Inventor: MARUNAKA, Masao c/o Research and Development Center, Hyogo 665-8550 (JP); TSUCHIYA, Takayuki c/o Research and Development Center, Hyogo 665-8550 (JP); TERAKURA, Atsuhiro c/o Research and Development Center, Hyogo 665-8550 (JP); TAKEUCHI, Kiyoshi c/o Research and Development Center, Hyogo 665-8550 (JP)
(74) Representative: Piésold, Alexander James
(86) International application number: PCT/JP2006/323760
(87) International publication number: WO 2007/066548

(57) **Abstract**

A sheet plasma film forming apparatus (100) of the present invention includes: a plasma gun (40) which can emit source plasma (22) in a transport direction; a sheet plasma converting chamber (20) including a transport space (21) extending in the transport direction; a pair of first magnetic field generating means (24A, 24B) disposed so as to sandwich the transport space (21) such that same poles thereof face each other; a film forming chamber (30) including a film forming space (31) which communicates with the transport space (21); and a pair of second magnetic field generating means (32, 33) disposed so as to sandwich the film forming space such that different poles thereof face each other, wherein: while moving in the transport space (21), the source plasma (22) is converted by a magnetic field of the pair of first magnetic field generating means (24A, 24B) into sheet-shaped plasma spreading along a main surface S including a center; and while moving in the film forming space (31), the sheet-shaped plasma 27 is caused to convexly project from the main surface S by a magnetic field of the pair of second magnetic field generating means (32, 33).

## Description

### Technical Field

The present invention relates to a sheet plasma film forming apparatus, and more particularly to an improvement of a vacuum sputtering technique using a collision of charged particles in sheet-shaped plasma with respect to a target.

### Background Art

It is known that uniform, high-density sheet-shaped plasma can be formed by sandwiching columnar plasma between a pair of permanent magnets which are disposed such that the same magnetic poles (north poles for example) thereof face each other and generate a strong repulsive magnetic field (see Patent Document 1).

In addition, the following sputtering technique has already been developed: the sheet-shaped plasma is introduced into a film forming space formed between a target and a substrate; target materials (sputter particles) are dislodged by sputtering using charged particles (positive ions) in the sheet-shaped plasma; the sputter particles are ionized by passing through the sheet-shaped plasma; and the sputter particles spatter and are deposited on the surface of the substrate (see Patent Document 2).
Patent Document 1: Japanese Examined Application Publication No. Hei. 4-23400
Patent Document 2: Japanese Laid-Open Patent Application Publication No. 2005-179767

### Disclosure of the Invention

### Problems to be Solved by the Invention

In order to adapt to the decrease in size and the increase in speed of semiconductor devices, the present inventors are addressing developments of a vacuum film forming technique of forming, by applying the sheet-shaped plasma technique, a high-quality metal (copper for example) wiring film on wiring grooves of a substrate, which technique was difficult to achieve by existing techniques.

In a process of such developments, a problem arises where in the case of applying a transfer passage of the sheet plasma technique described in, for example, Patent Document 2 as a transfer passage used when the sheet-shaped plasma is caused to move so as to go across a vacuum film forming chamber, entrances of the wiring grooves of the substrate are blocked by film forming particles (Cu sputter particles for example).

The present invention was made under such circumstances, and an object of the present invention is to provide a sheet plasma film forming apparatus capable of improving the film property of the wiring film formed on the wiring grooves of the substrate in the case of adopting the sheet-shaped plasma technique.

### Means for Solving the Problems

As a result of diligent study by the present inventors, it is found that the above problem can be appropriately solved by causing the sheet-shaped plasma to convexly project by a magnetic field.

For example, it has been gradually found that in the case of forming by sputtering copper wirings on wiring grooves constituting a fine wiring pattern, Cu particles dislodged by charged particles (positive ions) in the sheet-shaped plasma reach the wiring grooves by causing the sheet-shaped plasma to bend from its main surface while being arranged in a desired direction such that blocking of the entrances of the wiring grooves by the Cu particles is suppressed, and the Cu particles are appropriately embedded in the wiring grooves, as compared to the sheet-shaped plasma technique described in Patent Document 2.

A sheet plasma film forming apparatus according to the present invention includes: a plasma gun which generates, by electrical discharge, source plasma distributed at a substantially uniform density with respect to a center in a transport direction of plasma and is able to emit the source plasma in the transport direction; a sheet plasma converting chamber including a transport space extending in the transport direction; a pair of first magnetic field generating means disposed so as to sandwich the transport space such that same poles thereof face each other; a film forming chamber including a film forming space which communicates with the transport space; and a pair of second magnetic field generating means disposed so as to sandwich the film forming space such that different poles thereof face each other, wherein: while moving in the transport space, the source plasma is converted by a magnetic field of the pair of first magnetic field generating means into sheet-shaped plasma spreading along a main surface including the center; and while moving in the film forming space, the sheet-shaped plasma is caused to convexly project from the main surface by a magnetic field of the pair of second magnetic field generating means.
In accordance with the configuration of the sheet plasma film forming apparatus, the film forming performance of the apparatus can be improved by causing the sheet plasma to convexly project from the main surface based on the magnetic field. For example, the directional characteristics of the sputter particles improve when depositing the sputter particles on the wiring grooves by sputtering. Thus, the effect of appropriately embedding the sputter particles on the wiring grooves of the substrate and the effect of suppressing blocking of the wiring grooves by the sputter particles are achieved.
Here, the pair of second magnetic field generating means may be a pair of magnet coils, and normal lines of coil surfaces of the magnet coils may incline with respect to the main surface.

Thus, it is possible to appropriately cause the sheet plasma to convexly project from the main surface based on the magnetic field of the magnet coils.

Here, the sheet plasma film forming apparatus may further include: a target holder to which a target is attached; and a substrate holder to which a substrate on which materials of the target dislodged by charged particles in the sheet-shaped plasma are deposited is attached, wherein: the target and the substrate may be disposed so as to be spaced apart from each other in a thickness direction of the sheet-shaped plasma, to sandwich the sheet-shaped plasma, and to face each other in the film forming space; and the sheet-shaped plasma may have a bent portion which projects in the thickness direction of the sheet-shaped plasma from the main surface toward the target.
By causing the sheet plasma to bend based on the magnetic field, the effect of appropriately embedding the sputter particles on the wiring grooves and the effect of suppressing the blocking of the wiring grooves are expected to be obtained.
The sheet-shaped plasma may bend so as to have a substantially constant curvature radius. In this case, each of the normal lines of the coil surfaces of the magnet coils may incline toward the target at a predetermined inclination angle with respect to the main surface.

Moreover, the bent portion of the sheet-shaped plasma may have a peak portion that is a most projected portion from the main surface, and an upper limit of the inclination angle may be set such that a surface of the target is not subjected to the charged particles of the sheet-shaped plasma located at the peak portion.
This configuration is preferable since the contact between the sheet plasma and the target (conduction state like a circuit) can be avoided, and the bias voltage (negative voltage) can be appropriately applied to the target.

The above object, other objects, features, and advantages of the present invention will be made clear by the following detailed explanation of preferred embodiments with reference to the attached drawings.

### Effects of the Invention

The present invention provides a sheet plasma film forming apparatus capable of improving a film property of a wiring film formed on wiring grooves of a substrate.

### Brief Description of the Drawings

[Fig. 1] Fig. 1 is a schematic diagram showing a configuration example of a sheet plasma film forming apparatus according to an embodiment of the present invention.
[Figs. 2] Figs. 2 are schematic diagrams for schematically explaining a method for forming sheet plasma.
[Figs. 3] Figs. 3 are diagrams schematically showing how materials of a sputtering target spatter by charged particles of the sheet plasma in the case of causing the sheet plasma to bend and in the case of not causing the sheet plasma to bend.
[Figs. 4] Figs. 4 are reproduced diagrams of cross-sectional pictures showing a result of an experiment of causing Cu particles to be deposited on wiring grooves of a substrate in the case of causing the sheet plasma to bend and in the case of not causing the sheet plasma to bend.

### Explanation of Reference Numbers

- 11: flange
- 12: first magnet coil
- 20: sheet plasma converting chamber
- 21: transport space
- 22: columnar plasma
- 23: second magnet coil
- 24A,: 24B bar magnet
- 25, 36: vacuum pump
- 26, 37: valve
- 27: sheet plasma
- 27A: bent portion
- 27B: peak portion
- 28: bottle neck portion
- 29: passage
- 30: vacuum film forming chamber
- 31: film forming space
- 32: third magnet coil
- 33: fourth magnet coil
- 32A,: 33A coil surface
- 32B,: 33B normal line
- 34A: substrate holder
- 34B: substrate
- 35A: target holder
- 35B: target
- 38: permanent magnet
- 40: plasma gun
- 50: wiring groove
- 51: Cu deposited film
- 52: hole
- 100: sheet plasma film forming apparatus
- A: anode
- K: cathode
- P: transport center
- S: main surface

### Best Mode for Carrying Out the Invention

Hereinafter, a preferred embodiment of the present invention will be explained in reference to the drawings.

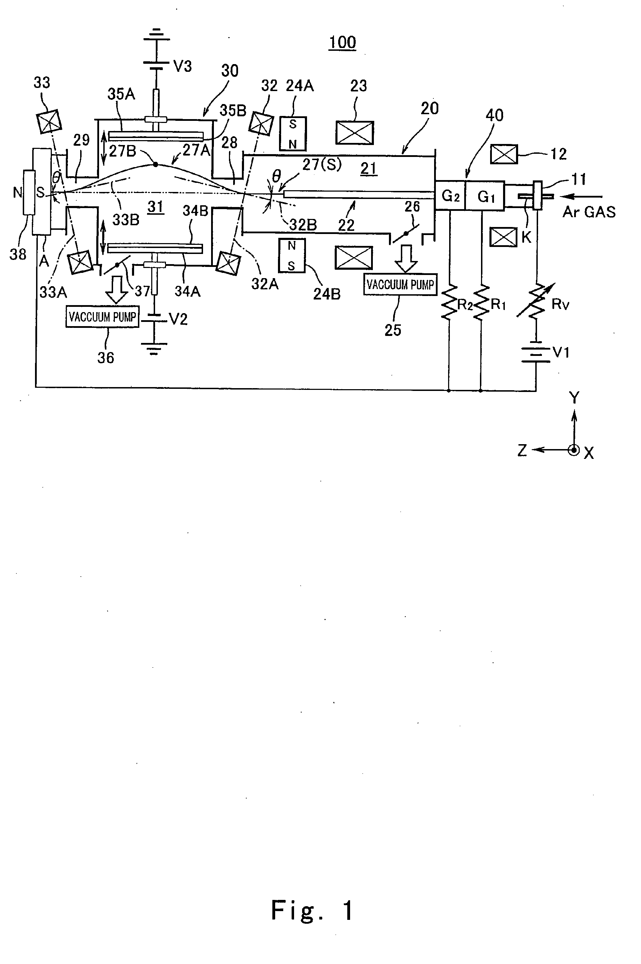

Fig. 1 is a schematic diagram showing a configuration example of a sheet plasma film forming apparatus according to an embodiment of the present invention.

Hereinafter, the sheet plasma film forming apparatus of the present embodiment will be explained in reference to Fig. 1.

For convenience sake, the configuration of the sheet plasma film forming apparatus will be explained on the basis that as shown in Fig. 1, a direction of plasma transport is a Z direction, a direction which is orthogonal to the Z direction and is a magnetization direction of bar magnets 24A and 24B (will be described later) is a Y direction, and a direction which is orthogonal to both the Z direction and the Y direction is an X direction.

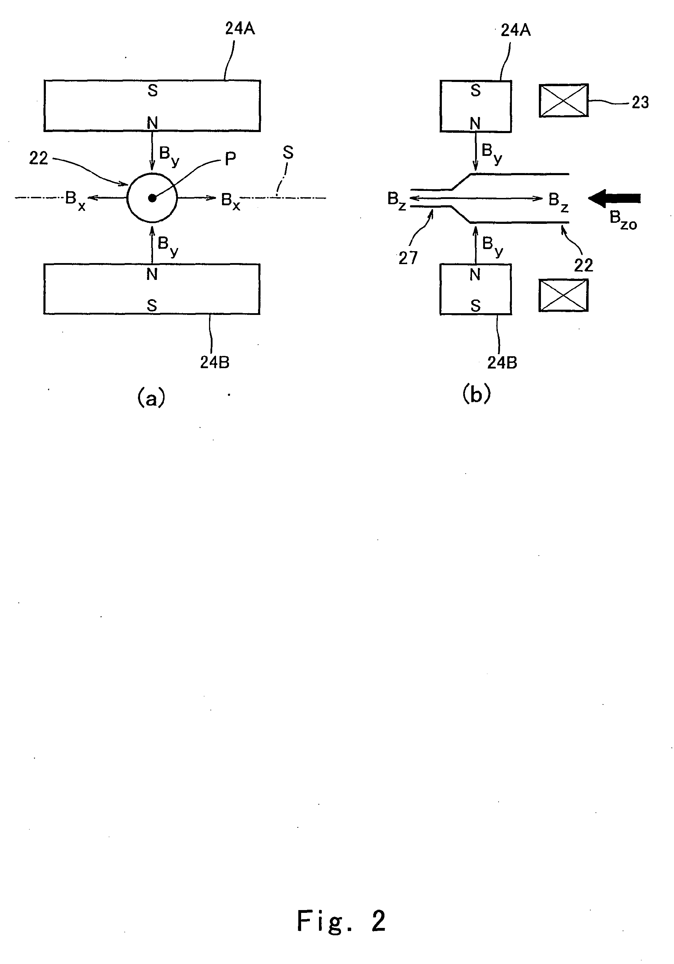

As shown in Fig. 1, a sheet plasma film forming apparatus 100 of the present embodiment has a substantially cross shape on a Y-Z plane. The sheet plasma film forming apparatus 100 of the present embodiment is configured to include a plasma gun 40 which generates plasma densely, a cylindrical non-magnetic (stainless steel or glass for example) sheet plasma converting chamber 20 whose center is an axis extending in the Z direction, and a cylindrical non-magnetic (stainless steel for example) vacuum film forming chamber 30 whose center is an axis extending in the Y direction, which are arranged in this order when viewed from the plasma transport direction (Z direction). Note that these members 40, 20 and 30 are hermetically in communication with one another via passages for transporting plasma.
The plasma gun 40 includes a discharge space (not shown) whose pressure can be reduced. A flange 11 (cathode mount) is disposed on a Z-direction first end of the plasma gun 40 so as to close the discharge space. On the flange 11, a cathode K which emits thermoelectrons for plasma discharge induction is disposed. Moreover, on the flange 11, gas introducing means (not shown) for introducing an argon (Ar) gas as a discharge gas to be ionized by this discharge to the discharge space is disposed.
Moreover, to maintain the plasma discharge (glow discharge) between the cathode K and the plasma gun 40, a pair of grid electrodes G₁ and G₂ (intermediate electrodes) to which a predetermined positive voltage is applied by a combination of a DC power source V1 and suitable resistors Rv, R₁ and R₂ are disposed at an appropriate position of the discharge space of the plasma gun 40. Note that the cathode K is connected to a negative terminal of the power source V1 via the resistor Rv, and a below-describe anode A is connected to a positive terminal of the power source V1. The grid electrode G₁ is connected to the positive terminal of the power source V1 via the resistor R₁, and the grid electrode G₂ is connected to the positive terminal of the power source V1 via the resistor R₂.
By the plasma discharge, plasma constituted by charged particles (here, Ar⁺ and electrons) is formed in the discharge space of the plasma gun 40.
Note that adopted herein is the plasma gun 40 of a known pressure gradient type which realizes the high-density plasma discharge between the cathode K and the anode A (will be described later) by DC arc discharge of low voltage and large current based on the power source V1.
Around the plasma gun 40, an annular first magnet coil 12 (air-core coil) is disposed so as to surround the circumference of a side surface of the plasma gun 40. By supplying a current to a winding wire of the first magnet coil 12, a Z-direction gradient of a magnetic flux density based on a coil magnetic field is formed in the discharge space of the plasma gun 40. By the Z-direction gradient of the magnetic flux density, the charged particles constituting the plasma proceed in the Z direction (direction toward the anode A) while circling around the line of magnetic force, so as to move in the Z direction from the discharge space. Then, as columnar source plasma (hereinafter referred to as "columnar plasma 22") which distributes at a substantially uniform density with respect to a transport center P (see Fig. 2) in Z direction, the plasma constituted by the charged particles is drawn to the sheet plasma converting chamber 20 via a passage (not shown) extending between a Z-direction second end of the plasma gun 40 and a Z-direction first end of the sheet plasma converting chamber 20.
The sheet plasma converting chamber 20 includes a columnar transport space 21 whose center is an axis extending in the Z direction and whose pressure can be reduced. The vacuuming of the transport space 21 is carried out using a vacuum pump 25 (turbopump for example) through an exhaust port which is openable and closable by a valve 26. Thus, the pressure of the transport space 21 is reduced to a level of the degree of vacuum that the columnar plasma 22 can be transported in the transport space 21.
Around the side surface of the sheet plasma converting chamber 20, an annular second magnet coil 23 (air-core coil) is disposed so as to surround the sheet plasma converting chamber 20 to generate a force of causing the columnar plasma 22 to proceed in the Z direction. Note that a current flowing in such a direction that the cathode K side is the south pole and the anode A side is the north pole is supplied to a winding wire of the second magnet coil 23.
Moreover, a pair of square bar magnets 24A and 24B (permanent magnets; a pair of first magnetic field generating means) are disposed on a Z-direction front side (side close to the anode A) of the second magnet coil 23 so as to sandwich the sheet plasma converting chamber 20 (transport space 21), to be arranged such that the same poles thereof (herein, the north poles thereof) face each other, to be magnetized in the Y direction, to extend in the X direction, and to be spaced apart from each other in the Y direction by a predetermined distance.
While the columnar plasma 22 moves in the Z direction in the transport space 21 of the sheet plasma converting chamber 20, due to an interaction of a coil magnetic field generated in the transport space 21 of the sheet plasma converting chamber 20 by supplying the current to the winding wire of the second magnet coil 23 and a magnet magnetic field generated in the transport space 21 by the bar magnets 24A and 24B, the columnar plasma 22 is converted into uniform sheet-shaped plasma (hereinafter referred to as "sheet plasma 27") which spreads along an X-Z plane (hereinafter referred to as "main surface S") including a transport center P extending in the transport direction (Z direction).
Hereinafter, a method for converting the columnar plasma 22 into the sheet plasma 27 by the magnetic field interaction caused by the second magnet coil 23 and the pair of bar magnets 24A and 24B will be described in reference to Fig. 2.
Figs. 2 are schematic diagrams for schematically explaining a method for forming the sheet plasma. Fig. 2(a) is a schematic diagram of a cross section which is in parallel with an X-Y plane and is in the vicinity of substantially a Z-direction center of the bar magnet, and Fig. 2(b) is a schematic diagram of a cross section which is in parallel with the Y-Z plane and is in the vicinity of substantially an X-direction center of the bar magnet.
In Fig. 2, Bx denotes a magnetic flux density vector component in the X direction of Fig. 1, By denotes a magnetic flux density vector component in the Y direction, and Bz denotes a magnetic flux density vector component in the Z direction.
As can be seen in Fig. 2(b), an initial magnetic flux density component Bz0, acting in the Z direction, of the columnar plasma 22 which has not yet reached the bar magnet 24A or 24B, is generated by the magnetic field of the second magnet coil 23. It is necessary to set the position of the second magnet coil 23 and the amount of current supplied to the winding wire of the second magnet coil 23 in order to appropriately maintain a magnitude correlation between the initial magnetic flux density component Bz0 and a Z-direction magnetic flux density component Bz formed by the pair of bar magnets 24A and 24B. It is thought that if this magnitude correlation therebetween is not appropriately maintained, the shape of the plasma is distorted (for example, the generation of so-called horn) when converting the columnar plasma 22 into the sheet-shaped plasma 27, so that it becomes difficult to uniformly spread the columnar plasma 22 along the main surface S.
Next, as can be seen in Fig. 2(a), on the X-Y plane, a pair of Y-direction magnetic flux density components By are formed so as to approach to the transport center P from respective north pole surfaces of the pair of bar magnets 24A and 24B, and a pair of X-direction magnetic flux density components Bx are formed so as to proceed in parallel with the north pole surfaces of the bar magnets 24A and 24B and to move away from each other from the transport center P.
Since the north pole surfaces of the bar magnets 24A and 24B are disposed so as to face each other, the pair of Y-direction magnetic flux density components By cancel each other as they approach to the transport center P from the north pole surfaces. Thus, a suitable negative gradient can be given to the Y-direction magnetic flux density components.
As shown by arrows of Fig. 2(a), such gradient of the Y-direction magnetic flux density components By causes the charged particles to move in the Y direction toward the transport center P such that the columnar plasma 22 is compressed. With this, the charged particles in the columnar plasma 22 proceed toward the transport center P while circling around the line of magnetic force.
Meanwhile, by appropriately designing the positions of the bar magnets 24A and 24B and the strength of the magnetic field generated by the bar magnets 24A and 24B, the pair of X-direction magnetic flux density component Bx can be adjusted such that a suitable negative gradient is given to the X-direction magnetic flux density components as the X-direction magnetic flux density components proceed in.the X direction so as to move away from each other from the transport center P.
As shown by arrows of Fig. 2(a), such gradient of the X-direction magnetic flux density components Bx causes the charged particles to move such that the columnar plasma 22 spreads along the main surface S (X-Z plane). With this, the charged particles in the columnar plasma 22 proceed so as to move away from the transport center P while circling around the line of magnetic force.
Thus, while moving in the sheet plasma converting chamber 20 in the Z direction, the columnar plasma 22 is uniformly converted into the sheet-shaped plasma 27 spreading along the main surface S based on the magnetic field interaction of the second magnet coil 23 and the bar magnets 24A and 24B. Note that the width and thickness of the sheet-shaped plasma 27, the density distribution of the charged particles, etc. are adjustable by suitably changing the magnetic flux densities Bx, By, Bz and Bz0.
As shown in Fig. 1, the sheet-shaped plasma 27 converted as above is drawn to the vacuum film forming chamber 30 via a slit-like bottle neck portion 28 through which the sheet-shaped plasma 27 passes, which portion is disposed between a Z-direction second end of the sheet plasma converting chamber 20 and a side wall of the vacuum film forming chamber 30. Note that the dimension (Y-direction size), thickness (Z-direction size) and width (X-direction size) of the bottle neck portion 28 are designed such that the bottle neck portion 28 allows the sheet plasma 27 to appropriately pass therethrough.
Adopted herein as the vacuum film forming chamber 30 is, for example, a vacuum sputtering apparatus which dislodges Cu materials of a target 35B as sputter particles by a collision energy of Ar⁺ in the sheet plasma 27.
The vacuum film forming chamber 30 includes a columnar film forming space 31 whose center is an axis extending in the Y direction, whose pressure can be reduced, and which is used for a sputtering process. The vacuuming of the film forming space 31 is carried out using a vacuum pump 36 (turbopump for example) through an exhaust port which is openable and closable by a valve 37. Thus, the pressure of the film forming space 31 is reduced to a level of the degree of vacuum that the sputtering process can be carried out.
The film forming space 31 may be understood by being functionally divided, by a center space which corresponds to the dimension of the bottle neck portion 28 and extends along a horizontal surface (X-Z plane), into a target space defined by an enclosing portion storing the plate-like copper target 35B and a substrate space defined by an enclosing portion storing a plate-like substrate 34B, in the vertical direction (Y direction).

In short, in a state in which the target 35B is attached to a target holder 35A, it is stored in the target space located above the center space. Moreover, the target 35B is configured to be movable upward and downward (Y direction) in the target space by a suitable actuator (not shown). Meanwhile, in a state in which the substrate 34B is attached to a substrate holder 34A, it is stored in the substrate space located below the center space. Moreover, the substrate 34B is configured to be movable upward and downward (Y direction) in the substrate space by a suitable actuator (not shown).

Note that the center space is a space which allows major components of the sheet plasma 27 to be transported therein in the vacuum film forming chamber 30. However, in the present embodiment, as will be described later, part of the sheet plasma 27 may go into the target space by causing the sheet plasma 27 to bend by the coil magnetic field.

Thus, the target 35B and the substrate 34B are disposed so as to be spaced apart from the sheet plasma 27 in the thickness direction (Y direction) by a certain suitable distance, to sandwich the sheet plasma 27 (center space) and to face each other in the film forming space 31.

During the sputtering process, the bias voltage, (negative voltage) is supplied to the target 35B by a DC power source V3. With this, Ar⁺ in the sheet plasma 27 is attracted toward the target 35B. As a result, the collision energy between Ar⁺ and the target 35B causes the sputter particles (copper particles for example) of the target 35B to be dislodged from the target 35B toward the substrate 34B.

Moreover, during the sputtering process, the bias voltage (negative voltage) is supplied to the substrate 34B by a DC power source V2. With this, the sputter particles (copper ions for example) which are ionized by the sheet plasma 27 by removing electrons thereof are accelerated toward the substrate 34B, and are deposited on the substrate 34B with increased adherence strength.

Next, the configuration around the vacuum film forming chamber 30 located so as to be opposed to the bottle neck portion 28 in the Z direction will be explained.
The anode A is disposed on a side wall of the vacuum film forming chamber 30 located as above. A passage 29 through which the plasma passes is disposed between the side wall and the anode A.
A suitable positive voltage (100 V for example) is applied between the anode A and the cathode K. With this, the anode A serves to collect the charged particles (especially, electrons) in the sheet plasma 27 by the DC arc discharge generated between the cathode K and the anode A.
Moreover, a permanent magnet 38 is disposed on a rear surface (surface opposite a surface facing the cathode K) of the anode A such that a south pole thereof is on the anode A side, and a north pole thereof is on an air side. Therefore, the sheet plasma 27 narrows in the width direction by the line of magnetic force which is emitted from the north pole of the permanent magnet 38, enters into the south pole and extends along the X-Z plane such that the width-direction (X-direction) spread of the sheet plasma 27 proceeding toward the anode A is suppressed. Thus, the charged particles of the sheet plasma 27 can be appropriately collected by the anode A.
Here, a pair of circular third and fourth magnet coils 32 and 33 (air-core coils; a pair of second magnetic field generating means) sandwich the film forming space 31 so as to face the side wall of the vacuum film forming chamber 30, and are disposed such that different poles face each other (herein, the north pole of the third magnet coil 32 and the south pole of the fourth magnet coil face each other), and normal lines 32B and 33B of coil surfaces 32A and 33A are inclined with respect to the main surface S of the sheet plasma 27 so as to form a substantially inverted V shape on the Y-Z plane.
More specifically, the third magnet coil 32 is disposed such that the winding wire of the third magnet coil 32 surrounds a Z-direction appropriate position located between the pair of bar magnets 24A and 24B and the vacuum film forming chamber 30, and the normal line 32B (central axis of the third magnet coil 32) of the coil surface 32A of the third magnet coil 32 extends toward the target 35B at an inclination angle θ with respect to the main surface S of the sheet plasma 27.
Moreover, the fourth magnet coil 33 is disposed such that the winding wire of the fourth magnet coil 33 surrounds a Z-direction appropriate position located between the side wall of the vacuum film forming chamber 30 and the anode A, and the normal line 33B (central axis of the fourth magnet coil 33) of the coil surface 33A of the fourth magnet coil 33 extends toward the target 35B at the inclination angle θ with respect to the main surface S of the sheet plasma 27.
In accordance with the coil magnetic field (about 10 G to 300 G for example) generated by supplying a current to the winding wires of the pair of third and fourth magnet coils 32 and 33, the sheet plasma 27 is shaped by a mirror magnetic field such that the width-direction (X-direction) spread of the sheet plasma 27 is appropriately suppressed while the sheet plasma 27 moves in the Z direction across the film forming space 31 of the vacuum film forming chamber 30.
Regarding the thickness direction (Y direction) of the sheet plasma 27, since the major components of the lines of magnetic force of the third and fourth magnet coils 32 and 33 on the Y-Z plane proceed along the normal lines 32B and 33B, the charged particles of the sheet plasma 27 also proceed so as to wind around the lines of magnetic force. With this, while the sheet plasma 27 moves in the Z direction across the film forming space 31 of the vacuum film forming chamber 30, the sheet plasma 27 convexly projects from the main surface S. Thus, the sheet plasma 27 has a bent portion 27A which projects in the thickness direction of the sheet plasma 27 toward the target 35B from the main surface S and bends in a fan shape so as to have a substantially certain curvature radius.
Herein, the bent portion 27A has a peak portion 27B that is the most projected portion from the main surface S of the sheet plasma 27, and the upper limit of the inclination angle θ is set such that the surface of the target 35B is not subjected to the charged particles of the sheet plasma 27 located at the peak portion 27B.

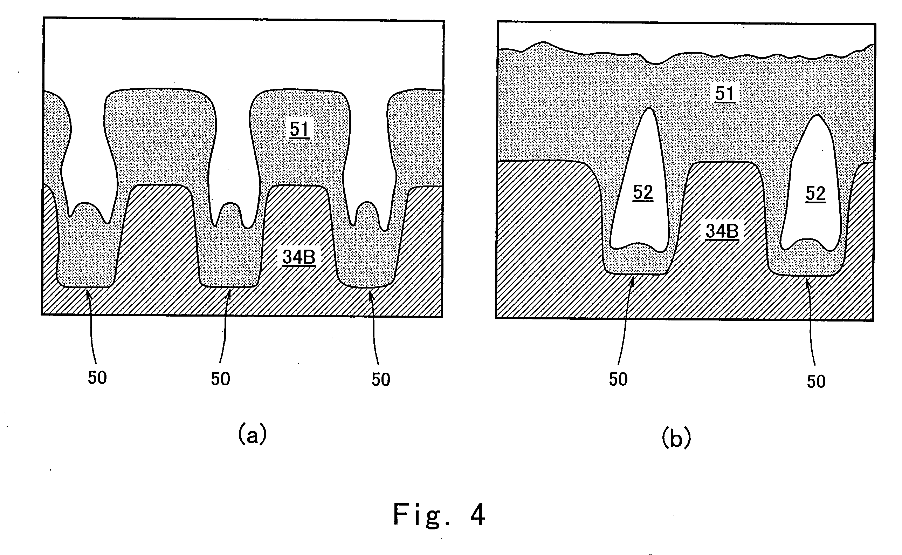

To be specific, the third and fourth magnet coils 32 and 33 are disposed so as to suitably limit maximum inclinations thereof so that the contact (conduction state like an electrical circuit) between the sheet plasma 27 and the target 35B can be avoided, and the bias voltage (negative voltage) can be appropriately applied to the target 35B.
In accordance with the sheet plasma film forming apparatus 100 described above, the following effects are expected by causing the sheet plasma 27 to bend based on the coil magnetic field when depositing the sputter particles on the wiring grooves (concave cross-sectional grooves) constituting a fine wiring pattern on the substrate. Such effects are supported by a result of an experiment (will be described later) of depositing the sputter particles on the wiring grooves.

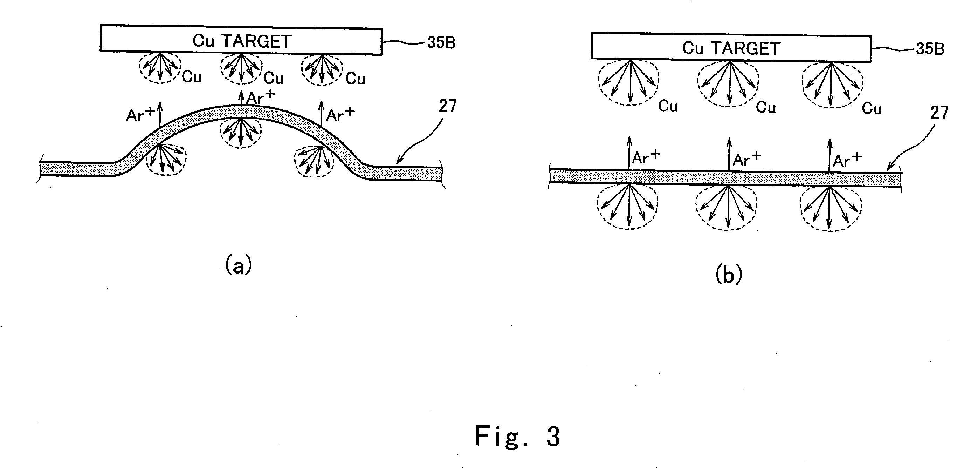

Figs. 3 are diagrams schematically showing how materials of the sputtering target spatter by the charged particles of the sheet plasma in the case of causing the sheet plasma to bend and in the case of not causing the sheet plasma to bend. Fig. 3(a) is a diagram corresponding to the case of causing the sheet plasma to bend, and Fig. 3(b) is a diagram corresponding to the case of not causing the sheet plasma to bend.
Here, in the case of not causing the sheet plasma 27 to bend, the positive ions (here, Ar⁺) in the sheet plasma 27 collide with substantially the entire surface of the target 35B in the vertical direction (Y direction in Fig. 1), as shown in Fig. 3(b). Therefore, an angular distribution of the sputter particles (here, Cu particles) dislodged by the collision energy of the positive ions shows the same tendency over the entire surface of the target 35B. In such a case, obliquely, randomly deviating components (for example, components proceeding in a direction significantly deviating obliquely with respect to the surface of the target 35B) among the sputter particles dislodged from the entire surface of the target 35B cannot get into the wiring grooves and are deposited in the vicinity of the entrances of the wiring grooves. Thus, the occurrence of a failure of embedding copper metal is a concern, such as blocking of the entrances.
In contrast; even in the case of causing the sheet plasma 27 to bend, as shown in Fig. 3(a), the positive ions emitted from the sheet plasma 27 collide with substantially the entire surface of the target 35B in the vertical direction, and the sputter particles dislodged by the collision of the positive ions are emitted toward the sheet plasma 27 so as to have a predetermined angular distribution as with Fig. 3(b). Meanwhile, as shown in Fig. 3(a), the sputter particles emitted from a peripheral portion of the target 35B and entering into the sheet plasma 27 are ionized when obliquely going across an inclined portion of the sheet plasma 27. As a result, it is thought that the sputter particles have vertical linear characteristics or slightly oblique directional characteristics due to a lens effect of the sheet plasma 27.
Specifically, since the sputter particles emitted from a center portion of the target 35B toward the sheet plasma 27 go across a flat portion of the sheet plasma 27, it is estimated that the major components of the sputter particles proceed in a direction perpendicular to the surface of the target 35B, and the sputter particles have a predetermined angular distribution whose central axis coincides with this direction under no influence of the lens effect of the sheet plasma 27. Moreover, since the sputter particles emitted from the peripheral portion of the target 35B toward the sheet plasma 27 go across an inclined portion of the sheet plasma 27, it is estimated that the major components of the sputter particles proceed in a predetermined oblique direction, and the sputter particles have a predetermined angular distribution whose central axis coincides with this direction, due to the lens effect of the sheet plasma 27.
Based on the above-described sputtering phenomenon caused by cooperation between the target 35B and the sheet plasma 27, the present inventors predict that since the major components of the sputter particles emitted from the vicinity of the center portion of the target 35B are directed toward a direction perpendicular to the substrate 34B, they are deposited on the bottom surfaces of the wiring grooves, while since the major components of the sputter particles emitted from the vicinity of the peripheral portion of the target 35B are directed toward a direction slightly oblique with respect to the substrate 34B, they are deposited on the bottom surfaces and side walls of the wiring grooves, which is preferable. Note that such spattering of the sputter particles in the oblique direction toward the side walls of the wiring grooves contributes to the improvement of coverage when depositing the sputter particles on the wiring grooves.
Meanwhile, the sputter particles which could not get into the wiring grooves and proceeded randomly in the oblique direction so as to close the entrances of the wiring grooves in the case of not causing the sheet plasma 27 to bend (Fig. 3(b)) proceed in the further oblique direction as shown in Fig. 3(a) showing the case of causing the sheet plasma 27 to bend, and such sputter particles cannot reach the wiring grooves on the substrate 34B. As a result, the failure of embedding copper metal is expected to improve.
As above, since the sheet plasma film forming apparatus 100 of the present embodiment causes the sheet plasma 27 to bend based on the magnetic field, the directional characteristics of the sputter particles improve when depositing the sputter particles on the wiring grooves by the sputtering. Thus, the effect of appropriately embedding the sputter particles on the wiring grooves of the substrate 34B and the effect of suppressing blocking of the wiring grooves by the sputter particles are achieved.
Experimental Example of Depositing Sputter Particles on Wiring Grooves
Figs. 4 are reproduced diagrams of cross-sectional pictures showing a result of an experiment of causing the Cu particles to be deposited on the wiring grooves of the substrate in the case of causing the sheet plasma to bend (inclination angle θ of approximately 10 degrees) and in the case of not causing the sheet plasma to bend. Fig. 4(a) is a diagram corresponding to the case of causing the sheet plasma to bend, and Fig. 4(b) is a diagram corresponding to the case of not causing the sheet plasma to bend.
In the present deposition experiment, parameters (for example, the degree of vacuum, the target voltage, the deposition period of time and the discharge current) other than the presence or absence of the bending of the sheet plasma 27 are common between these cases.
In accordance with the result of the experiment of depositing the Cu particles on the wiring grooves 50 of the substrate 34B in the case of not causing the sheet plasma 27 to bend, as shown in Fig. 4(b), since the entrances of the wiring grooves 50 are blocked by a Cu deposited film 51, the thickness of the Cu deposited film 51 in the wiring grooves 50 is not secured, and the existence of holes 52 is confirmed in the wiring grooves 50.
In contrast, in accordance with the result of the experiment of depositing the Cu particles on the wiring grooves 50 of the substrate 34B in the case of not causing the sheet plasma 27 to bend, as shown in Fig. 4(a), appropriate embedding of the Cu deposited film 51 in the wiring grooves 50 is confirmed.
Moreover, as shown in Fig. 4(a), it is confirmed that a problem of blocking the entrances of the wiring grooves 50 by the Cu deposited film 51 does not occur.
From the foregoing explanation, many modifications and other embodiments of the present invention are obvious to one skilled in the art. Therefore, the foregoing explanation should be interpreted only as an example, and is provided for the purpose of teaching the best mode for carrying out the present invention to one skilled in the art. The structures and/or functional details may be substantially modified within the spirit of the present invention.

### Industrial Applicability

The present invention is useful as a vacuum sputtering apparatus which can appropriately adjust the moving direction of the sheet plasma and for example, sputters the target by the charged particles of the sheet plasma.

## Claims

1. A sheet plasma film forming apparatus comprising:
a plasma gun which generates, by electrical discharge, source plasma distributed at a substantially uniform density with respect to a center in a transport direction of plasma and is able to emit the source plasma in the transport direction;
a sheet plasma converting chamber including a transport space extending in the transport direction;
a pair of first magnetic field generating means disposed so as to sandwich the transport space such that same poles thereof face each other;
a film forming chamber including a film forming space which communicates with the transport space; and
a pair of second magnetic field generating means disposed so as to sandwich the film forming space such that different poles thereof face each other, wherein:
while moving in the transport space, the source plasma is converted by a magnetic field of the pair of first magnetic field generating means into sheet-shaped plasma spreading along a main surface including the center; and
while moving in the film forming space, the sheet-shaped plasma is caused to convexly project from the main surface by a magnetic field of the pair of second magnetic field generating means.

2. The sheet plasma film forming apparatus according to claim 1, wherein:
the pair of second magnetic field generating means are a pair of magnet coils; and
normal lines of coil surfaces of the magnet coils incline with respect to the main surface.

3. The sheet plasma film forming apparatus according to claim 2 further comprising:
a target holder to which a target is attached; and
a substrate holder to which a substrate on which materials of the target dislodged by charged particles in the sheet-shaped plasma are deposited is attached, wherein:
the target and the substrate are disposed so as to be spaced apart from each other in a thickness direction of the sheet-shaped plasma, to sandwich the sheet-shaped plasma, and to face each other in the film forming space; and
the sheet-shaped plasma has a bent portion which projects in the thickness direction of the sheet-shaped plasma from the main surface toward the target.

4. The sheet plasma film forming apparatus according to claim 3, wherein the sheet-shaped plasma bends so as to have a substantially constant curvature radius.

5. The sheet plasma film forming apparatus according to claim 3, wherein each of the normal lines of the coil surfaces of the magnet coils inclines toward the target at a predetermined inclination angle with respect to the main surface.

6. The sheet plasma film forming apparatus according to claim 5, wherein:
the bent portion of the sheet-shaped plasma has a peak portion that is a most projected portion from the main surface; and
an upper limit of the inclination angle is set such that a surface of the target is not subjected to the charged particles of the sheet-shaped plasma located at the peak portion.
